# EUROPEAN PATENT APPLICATION

(11) **EP 4 738 626 A1**
(43) Date of publication of application: **06.05.2026**
(21) Application number: 24209446.4
(22) Date of filing: 29.10.2024
(51) Int. Cl.: H01S 5/0687, H01S 5/40, H01S 5/062, H01S 3/13, H01S 5/06

(54) **METHOD AND SYSTEM FOR LASER INJECTION LOCKING**

(71) Applicant: Eberhard Karls Universität Tübingen, 72074 Tübingen (DE)
(72) Inventor: Groß, Christian, 72144 Dußlingen (DE); de Martino, Alexandre, 72076 Tübingen (DE); Auch, Jonas, 72076 Tübingen (DE); Karpov, Kirill, 72074 Tübingen (DE); Kiesel, Florian, 72070 Tübingen (DE)
(74) Representative: Hoffmann Eitle

(57) **Abstract**

Provided is method for injection locking a first laser onto a second laser, the method comprising the steps of: a) providing at least part of light emitted by the first laser to the second laser; b) continuously changing an input parameter of the second laser until a value at which a signal of the second laser shifts is reached; c) adding the value at which the signal of the second laser shifts to a set of values; d) repeating steps b) and c) until the set of values converges to a convergence value; and e) setting the input parameter of the second laser based on the convergence value, thereby injection locking the first laser onto the second laser.

## Description

The present disclosure relates to a method for laser injection locking, specifically injection locking a first laser onto a second laser. Moreover, it relates to a system for injection locking.

### Background

For many applications involving laser light, it is highly desirable to generate high output power at the same time as achieving narrow line single mode lasing. Unfortunately, these two characteristics are often mutually exclusive and/or technically demanding to achieve for available lasers/laser diodes such that efficient and scalable amplification of narrow line laser light remains a major driving point in current development of laser system designs.

One approach to address this is injection locking (also referred to as "laser injection locking"). Injection locking relates to forcing the spectral characteristics of a first laser, sometimes referred to as seed laser or master laser, onto a second laser, sometimes referred to as slave laser, by optically injecting laser light from the first laser into the second laser. For this to work, the second laser's parameter, such as its temperature and its current, must be tuned to match its cavity with the laser light injected from the first laser.

While injection locking, in particular of high-power semiconductor laser diodes, is able to address this problem in many scenarios it remains challenging to achieve (long-term) stable operation of the injection locked state due to the complex interplay of the non-linear effects as well as the thermal effects involved in injection locking.

In view of these difficulties, conventional approaches of injection locking, no matter whether they are based on active or passive stabilization, typically require a large amount of optical and/or electrical equipment and can only applied to specific scenarios on a limited scale but are neither generally applicable nor scalable. Moreover, despite the amount of additional equipment employed in conventional approaches, long-term stability is often difficult to achieve.

Hence, there is a need for an injection locking technique that allows for long-term stability of the system that at the same time is generally applicable as well as scalable.

### Summary

The present disclosure has been made in view of the above technical limitations of the currently available solutions for injection locking and thus provides a method and a system for injection locking that overcomes these limitations.

In particular, the present disclosure is based on understanding the thermalization characteristics of the laser to be injection locked and exploiting the same. Based on this, the present disclosure is able to provide long-term stable injection locking without the need of a large amount of optical and/or electrical equipment and without being tailored to the specifics of the setup such that the present disclosure allows generally applicable and scalable injection locking.

According to an aspect of the present disclosure, a method for injection locking a first laser onto a second laser is provided, the method comprising the steps of: a) providing at least part of light emitted by the first laser to the second laser; b) continuously changing an input parameter of the second laser until a value at which a signal of the second laser shifts is reached; c) adding the value at which the signal of the second laser shifts to a set of values; d) repeating steps b) and c) until the set of values converges to a convergence value; and e) setting the input parameter of the second laser based on the convergence value, thereby injection locking the first laser onto the second laser.

According to another aspect of the present disclosure, a system for injection locking a first laser onto a second laser is provided, the system comprising the first laser, the second laser, and a control unit, wherein the first laser is configured to provide at least part of light emitted by the first laser to the second laser, and the control unit is configured to perform the steps of: a) continuously changing an input parameter of the second laser until a value at which a signal of the second laser shifts is reached; b) adding the value at which the signal of the second laser shifts to a set of values; c) repeating steps a) and b) until the set of values converges to a convergence value; and d) setting the input parameter of the second laser based on the convergence value, thereby injection locking the first laser onto the second laser.

In addition, preferred aspects of the present disclosure are defined in the dependent claims.

According to the invention, an improved injection locking can be provided, in particular a long-term stable, generally applicable and scalable injection locking can be provided.

### Brief description of the drawings

Embodiments of the present disclosure, which are presented for better understanding the inventive concepts, but which are not to be seen as limiting the disclosure, will be described with reference to the figures in which:
- Fig. 1: shows a flow chart of a method for injection locking according to the present disclosure;
- Fig. 2: shows an illustration of a system for injection locking according to the present disclosure;
- Fig. 3: shows an illustration of possible behavior of the signal of the second when changing the input parameter of the second laser;
- Fig. 4A: shows various iterations of the signal of the second laser while the input parameter of the second laser is changed according to the present disclosure;
- Fig. 4B: shows convergence of the various iterations of Fig. 4A; and
- Fig. 5: shows spectral characteristics of a second laser injection locked to a first laser according to the present disclosure.

### Detailed description

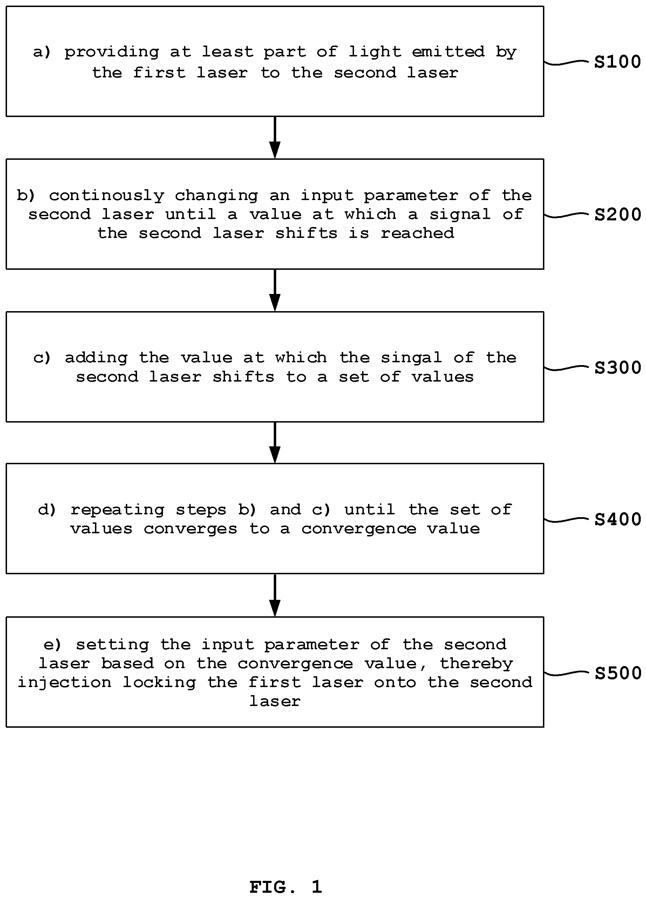

Fig. 1 shows a flow chart of a method for injection locking according to the present disclosure, specifically of a method for injection locking a first laser onto a second laser.

Here, "injection locking a first laser onto a second laser" may mean that a signal from the first laser is provided to the second laser such that the spectral characteristics and/or frequency of light emitted by the second laser corresponds to the spectral characteristics and/or frequency of light emitted by the first laser. That is, the second laser is locked into the spectral characteristics of the first laser. This may also be read as "injection locking a frequency of a first laser onto a second laser" or "injection locking a frequency of a first laser onto a frequency of a second laser". Equally, this may be understood as "the second laser is injection locked to the first laser". It is thus a matter of perspective whether the first laser is injection locking onto the second laser or whether the second laser is injection locked to the first laser.

In this manner, by choosing appropriately the first and second laser, the spectral characteristics of narrow line single mode lasing (from the first laser) can be combined with a high output power (from the second laser). This is one central aspect making injection locking an important tool for many laser applications, in particular in the field of atomic, molecular and optical physics as well as in quantum technologies in general.

The first laser may be referred to as master laser and/or seed laser. The first laser may be a laser that can, on its own, that is, in particular without injection locking, emit laser light with desired spectral characteristics such as in a desired frequency range. The first laser may be a laser with (relatively) low output power. The first laser may be stabilized to an external reference.

The second laser may be referred to as the slave laser. The second laser may be a laser that cannot, on its own, that is, in particular, without injection locking, emit laser light with desired spectral characteristics such as in a desired frequency range. For example, the second laser may emit light within a desired frequency range, but its frequency may not be (sufficiently) stable and its spectral line may not be as (narrows as) desired but broader. The second laser may be a laser with (relatively) high output power.

Further, the second laser may be more than one laser, i.e., more than one second laser can be injection locked by the first laser. This can either be achieved in parallel, i.e., the first laser provides at least part of its emitted light to more than one second laser, or in series, i.e., the first laser provides at least part of its emitted light to one second laser, thus being injection locked, and then the second laser provides at least part of its emitted light to a further second laser. It is evident that these options can be combined and thus a cascade of injection locked lasers and injection locking lasers can be achieved.

As mentioned above, for injection locking to work, it is important that the parameters of the second laser are such that the light injected from the first laser can lock the light emitted by the second laser onto the frequency of the first laser. This in particular relates to the interplay between the frequency of the light of the first laser, the parameters controlling the cavity of the second laser and operation parameters of the second laser such as its temperature and its current.

Further, while injection locking is generally understood and well-established such that achieving injection locking typically does not present a challenge, maintaining the injection locked state, i.e., maintaining the injection locking, for a longer period of time due to the complex interplay between various non-linear thermal effects.

In more details, Fig. 1 shows a flow chart of a method for injection locking a first laser onto a second laser, wherein the method comprises the steps of: a) providing (step S100) at least part of light emitted by the first laser to the second laser; b) continuously changing (step S200) an input parameter of the second laser until a value at which a signal of the second laser shifts is reached; c) adding (step S300) the value at which the signal of the second laser shifts to a set of values; d) repeating (step S400) steps b) and c) until the set of values converges to a convergence value; and e) setting (step S500) the input parameter of the second laser based on the convergence value, thereby injection locking the first laser onto the second laser.

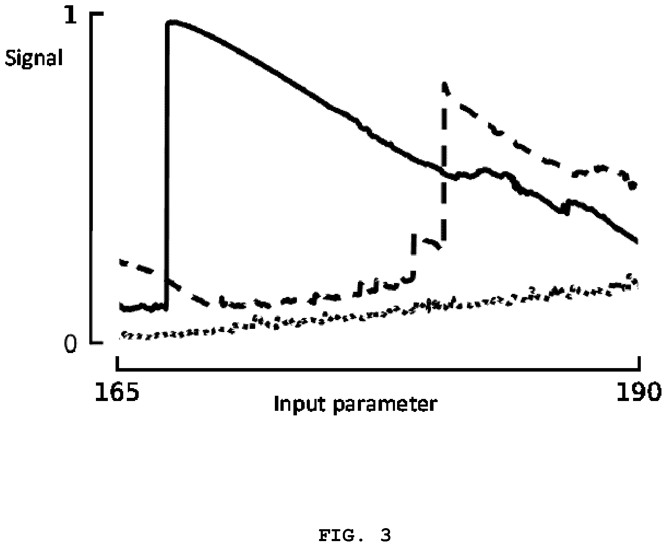

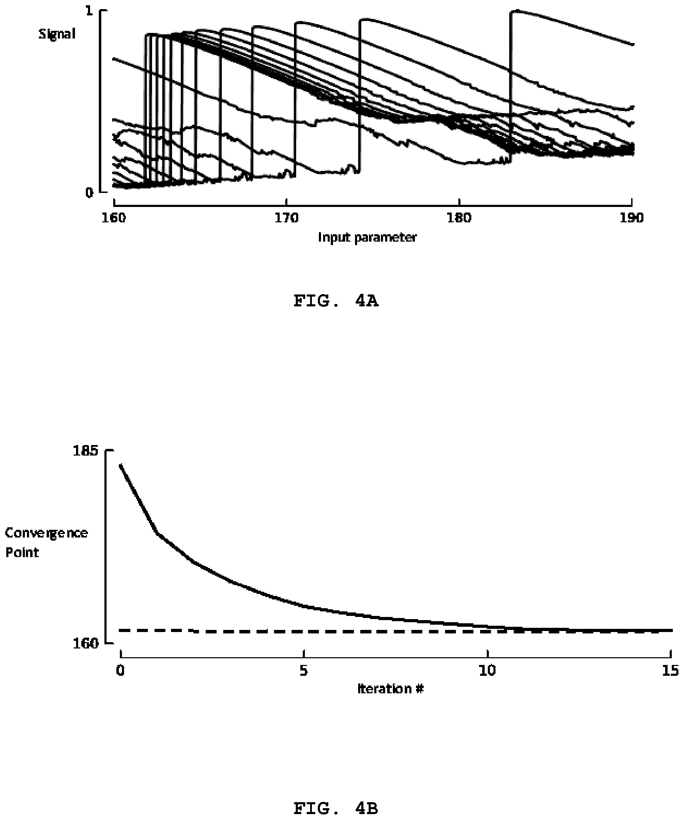

The "changing" in step b) may be an "increasing" or a "decreasing". Moreover, the changing may be monotonous. Thus, step b) may refer to (monotonous) "continuously decreasing" or "continuously increasing". Further details of this will be discussed in the context of Fig. 3 and Figs. 4A and 4B.

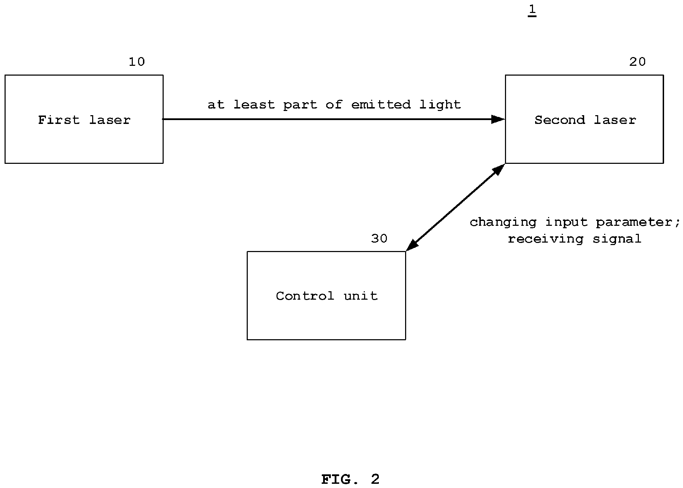

The signal may be an internal signal or may be an external signal. Details of this will be discussed in the context of Fig. 2.

Further, the "shift" reached in step b) may also be referred to as a "transition", i.e., the signal of the second laser may transition.

Moreover, in the case of continuously decreasing the input parameter of the second laser (also referred to as a "sweep down"), the shift/transition is a "drop", that is, the signal of the second laser "drops". Correspondingly, in the case of continuously increasing the input parameter of the second laser (also referred to as a "sweep up"), the shift/transition is a "rise", that is, the signal of the second laser "rises". Further details of this will be discussed in the context of Fig. 3 and Figs. 4A and 4B.

It is noted that the present disclosure is not limited to either direction, i.e., relates to continuously decreasing as well as continuously increasing. Whether one or the other option may be advantageous may be dependent on whether, for example, an internal photodiode or an external photodiode is used.

Further, as explained above, by setting the input parameter based on the convergence value injection locking of the first laser onto the second laser is achieved.

In other words, according to the present disclosure, injection locking, in particular long-time stable injection locking, can be achieved by observing a convergence/a convergence value of the signal of the second laser when changing an input parameter and setting the input parameter based on this convergence value.

Fig. 2 shows an illustration of a system for injection locking according to the present disclosure. Specifically, Fig. 2 shows a system 1 for injection locking a first laser 10 onto a second laser 20, the system 1 comprising the first laser 10, the second laser 20, and a control unit 30, wherein the first laser 10 is configured to provide (also: inject) at least part of light emitted by the first laser 10 to the second laser 20, and the control unit 30 is configured to perform the steps of: a) continuously changing an input parameter of the second laser until a value at which an signal of the second laser shifts is reached; b) adding the value at which the signal of the second laser shifts to a set of values; c) repeating steps a) and b) until the set of values converges to a convergence value; and d) setting the input parameter of the second laser based on the convergence value, thereby injection locking the first laser onto the second laser.

It can thus be understood that the system is configured to perform methods for injection locking, for example as described above in the context of Fig. 1 and that the above considerations regarding the method steps apply correspondingly to the system 1 and its constituents.

Providing (or injecting) at least part of light emitted by the first laser 10 to the second laser 20 may be realized by means of a Faraday isolator and, additionally/optionally, a single-mode polarization-maintaining optical fiber.

It is noted that in view of the simplicity of the steps carried out by the control unit 30, this control unit 30 does not need to meet any particular requirements and can be a commonplace microcontroller or the like. That is, the present disclosure does not require any specific electronic equipment. Similarly, no particular optical equipment going beyond conventional elements such as an (integrated) photodiode, see also below, is required.

The first laser 10 and the second laser 20 used in system 1 are not particularly limited and may be applied to laser emitted in any frequency range, in particular in the frequency range of visible and infrared light, such as the frequency range of 390nm to 1200nm.

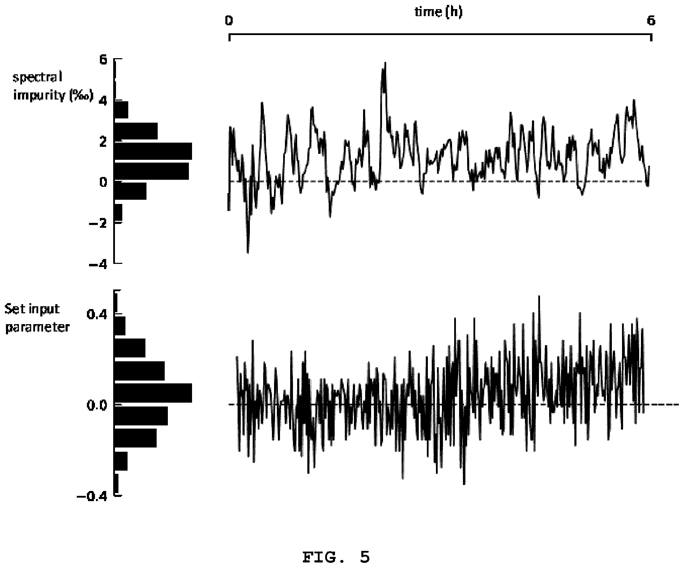

While the injection locking according to the present disclosure shows a long-term stability lasting longer than conventional approaches (for more details, we refer to the below discussion of Fig. 5), it can be readily understood that indefinitely lasting injection locking is not realistic. Accordingly, also injection locking according to the present invention will have to be performed regularly, albeit at much larger intervals, and can be automated.

There are various options how this "performed regularly" can be realized.

According to a first option, methods for injection locking according to the present disclosure may further comprise receiving a trigger input to perform the (automated) injection locking synchronously to an external event.

Correspondingly, in systems 1 for injection locking according to the present disclosure the control unit 30 may be further configured to receive a trigger input to perform the (automated) injection locking synchronously to an external event.

In other words, in the first option, an external event triggers the injection locking. This external event may be provided regularly, i.e., after predetermined intervals, for example every 1 minute. At the same time, the predetermined interval may also be up to 1 hour since this may depend on the environment and specifics of the laser diodes.

The external signal may be provided to all second lasers being injection locked synchronously and thus injection locking is performed synchronously. The resulting synchronicity of the injection locking among the second lasers may in particular be advantageous if more than one second laser is injection locked.

According to a second option, methods for injection locking according to the present disclosure may further comprise detecting that the second laser is not injection locked to the first laser, and performing the injection locking according to the detection.

Correspondingly, in systems 1 for injection locking according to the present disclosure the control 30 unit may be further configured to detect that the second laser is not injection locked to the first laser, and perform the injection locking according to the detection.

In other words, in the second option, the system detects if an injection lock state is "lost", i.e., a second laser 20 is no longer injection locked, and based on this determination the injection locking is (re-)performed. That is, in this second option, injection locking of each second laser is based on an assessment of the stability of the injection locking state of this second laser.

Such an assessment can, for example, be based on determining the spectral (im-)purity in which integrated power densities of the second laser in a free running mode and in the injection locked mode are evaluated. If the spectral impurity exceeds a predetermined threshold, this may be used to determine that the injection locked state is lost and hence injection locking has to be performed again. Further details of how to assess and evaluate the stability of injection locking according to the present disclosure will be discussed in the context of Fig. 5.

Such an option has the advantage that the trigger input/external event can be omitted, leading to an even simpler control of the system. Further, compared to a system in which the injection locking is performed after fixed time periods, the second option may allow for a need-based injection locking: If the system is less stable, this is addressed by more frequent injection locking; if the system is more stable, unnecessary injection locking iterations can be avoided. Hence, this option may improve performance of the overall laser output while also keeping the resources for the control and the number of injection locking iterations at a minimum.

As mentioned elsewhere within this disclosure, an output power of the second laser may be greater than an output power of the first laser. Here, output power may refer to a rated output power, that is, a maximum output power under normal operating conditions.

For example, the output of the first laser may be (about) 2mW, (about) 4mW, or (about) 5mW, while the output of the second laser may be up to (about) 100mW or even up to (about) 200mW. It is noted that if the output of the first laser is too low, in particular if the ratio between the output power between the first laser and the output power of the second laser is too small, this may negatively affect the possibility to achieve injection locking. This can, for illustrative purposes, be understood as the first laser being too weak to force the second laser into the injection locked state in which the second laser emits according to the light provided by the first laser.

This case may be a relevant use case of injection locking since in such a configuration the injection locking will lead to the second laser combining the spectral characteristics of the first laser with the output power of the second laser, resulting in the desirable combination of high output power and narrow line single mode lasing.

The first laser and the second laser may differ in at least one intrinsic property. Intrinsic property in this context may refer to a spectral property such as an intrinsic frequency range or an intrinsic spectral line. In other words, an intrinsic frequency range of the first laser may be different from an intrinsic frequency range of the second laser. Similarly, an intrinsic spectral line of the first laser may be different from an intrinsic spectral line of the second laser. It is noted that for injection locking to be possible a difference in frequency between the first and the second laser may be limited, i.e., may not be too large, in line with established knowledge of injection locking.

Here, "intrinsic" refers to the corresponding property when individually operated, that is, operated on its own, that is, without external manipulation such as injection locking. This may also be referred to as free running mode.

Accordingly, an "intrinsic frequency range" may refer to the frequency range during such a free running mode and an "intrinsic spectral line" may refer to the spectral line during such a free running mode.

The input parameter of the second laser may be a current applied to the second laser, or a voltage controlling the current applied to the second laser.

Further, the current applied to the second laser may be modulated with a triangular waveform. Preferably, the modulation takes place continuously, that is, the current applied to the second laser may be modulated continuously with a triangular waveform.

Moreover, the modulation may preferably be same throughout, i.e., when, in terms of the method, step a) of continuously changing an input parameter is repeatedly executed, and when the input parameter is set according to step d).

As mentioned above, the signal of the second laser may be an internal signal or may be an external signal. Specifically, the signal may be a signal of a photodiode integrated into the second laser. Preferably, the signal may be a photocurrent of the photodiode or a voltage converted from the photocurrent. Clearly, an externally provided photodiode may be used as well.

Fig. 3 shows an illustration of possible behavior of the signal of the second when changing the input parameter of the second laser.

Specifically, Fig. 3 shows the signal of the second laser as a function of the input parameter. As mentioned above the signal may be the signal of an integrated photodiode into the second laser, while the input parameter may be the current of the second laser.

The solid line shows the signal for the case of continuously decreasing (a "sweep down") the input while the second laser is provided with the seed light, i.e., part of the light emitted by the first laser, the dashed line shows the signal for the case of continuously increasing (a "sweep up") the input while the second laser is provided with the seed light, and the dotted, bottom line shows the signal for the case that no seed light is provided.

The solid and dashed line show typical injection resonance features with a dominant shift/transition (a drop in case of the solid line and a rise in case of the dashed line) at lower input parameter values. A strong hysteric behavior can be observed. Further, it can be observed that the "sweep down" shift has a larger magnitude and hence may be preferable.

In line with the above, n method step b), the input parameter of the second laser may be continuously decreased, or the input parameter of the second laser may be continuously increased. This would correspond to the solid line, i.e., the "sweep down" and the dashed line, i.e., the "sweep up", of Fig. 3.

Further, in method step b), it may be determined that the value at which the signal of the second laser shifts is reached by comparing subsequent values of the signal of the second laser.

Specifically, comparing subsequent values of the signal of the second laser may include comparing two subsequent values and determining whether a difference between the two subsequent values exceeds a first predetermined threshold; and/or may include determining a slope of the signal and determining whether the slope of the signal exceeds a second predetermined threshold.

In other words, numerical methods may be used to identify the jump visible in the solid line as well as the dashed line of Fig. 3, depending on whether a sweep down or a sweep up is used.

Further, in step b), continuously changing an input parameter of the second laser may be performed in discrete steps such that each value of the input parameter is held for a predetermined period of time. This may in particular serve to ensure that the corresponding value of the signal can be determined appropriately. The predetermined period of time may be (about) 0.1ms.

Each iteration of method step b) corresponds to a curve such as the solid line or the dashed line in Fig. 3.

Fig. 4A shows various iterations of the signal of the second laser while the input parameter of the second laser being changed according to the present disclosure. That is, Fig. 4A shows various subsequent iterations of the solid line of Fig. 3, wherein curves showing a jump further on the left, i.e., for lower values of the input parameter, correspond to later iterations, while curves showing a jump further on the right, i.e., for higher values of the input parameter, correspond to earlier iterations.

As clearly visible, the various iterations of method step b) converge a single curve and to a single value of the input parameter at which the shift occurs, i.e., to the convergence value of method step d).

It is this convergence of the relationship between input parameter and signal of the second laser that can be understood as a central aspect of the present invention since this thermalization behavior allows fast, simple and general injection locking.

This convergence of the various iterations shown in Fig. 4A is shown in Fig. 4B. Specifically, Fig. 4B shows the value at which the signal of the second laser shifts as a function of the number of iterations, that is, maps the set of values introduced in method step c) as a function of the number of iterations. As can readily be seen, the set of values converges to a convergence value, which can be used to set the input parameter of the second laser such that injection locking of the second laser to the first laser can be achieved.

It is noted that the plot shown in Fig. 4A, and consequently the convergence shown in Fig. 4B, corresponds to a case in which the second laser was in a free running mode, i.e., not injection locked. In case that the method for injection locking is performed in a system that was previously injection locked, for example, due to the injection locked state being lost or a trigger input to perform injection locking is received, much faster convergence is observed.

Moreover, it is noted that the overall process illustrated in Fig. 4A typically lasts around half a second, often less than 0.4 seconds, while the injection locked state achieved is stable for at least up to fifteen minutes, but may also reach several hours.

In method step c), it may be determined that the set of values converges by comparing last values of the set of values.

Specifically, comparing the last values of the set of values may include determining whether a difference between two last values is smaller than a third predetermined threshold; and/or may include determining whether a ratio between two last values is smaller than a fourth predetermined threshold.

Further, in method step d), the input parameter of the first laser may be set within a predetermined range of the convergence value.

Specifically, the input parameter of the second laser may be set to be equal to a sum of the convergence value and a first predetermined value; or the input parameter of the second laser may be set to be equal to a difference between the convergence and a second predetermined value.

Fig. 5 shows spectral characteristics of a second laser injection locked to a first laser according to the present disclosure.

In more detail, Fig. 5 shows, in the upper part, the spectral impurity in permille and, in the lower part, the variation of the set input parameter used to achieve injection locking.

As can be seen from the upper part of Fig. 5, this data corresponds to an experiment lasting 6 hours. Every one minute, injection locking in line with methods according to the present disclosure were performed and each time the injection locking was successful. Moreover, as can be seen, the spectral impurity never exceeded the detection limit, which in the present case was 6 permille. The mean spectral impurity observed over the full duration of six hours, see also the histogram on the left side, was 1,8 permille, i.e., clearly below the detection limit indicating that the present invention allows stable injection locking for such duration.

From the lower part of Fig. 5, it can be seen that the input parameter, in this case the current of the second laser, was within ±0.4mA throughout the full duration of six hours. While a drift of the system in the last three hours can be observed, leading to a mean shift in the set input parameter by 0.18mA, see also the histogram on the left side, it can be seen that this had no impact on the spectral impurity.

As a further explanation, the spectral purity *S* is herein defined as *S* = (*P_{lock}* - *P_{free}*)/(*P_{lock}* + *P_{free}*), where *P_{lock}* is the spectral power density of the second laser being injection locked light and *P_{free}* is the spectral power density of the second laser operating a free running mode. Correspondingly, the spectral impurity *S̅* is defined as *S̅* = 1 - *S*. For *S̅* = 0, all the optical power is in the injection locked mode, i.e., the mode of the seed light, and the system is called fully injection locked. For *S̅* = 1, the second laser is lasing exclusively in its free spectrum exclusively.

The long-term stability of the injection locking according to the present disclosure can also be understood as the present disclosure providing injection locking that is insensitive to thermal effects. In other words, the present disclosure can be understood as achieving injection locking within a thermally stable configuration of the second laser.

In summary, the present disclosure provides methods and systems for laser injection locking. Specifically, the present disclosure provides a method for injection locking using simple and fast to execute steps that do not require special optical or electrical equipment such that also the resulting system for injection locking is easy to implement.

Further, the herein presented injection locking can be applied generally since it does not rely on specific details of the lasers involved. Indeed, the observed convergence is not tied to any specific system. Additionally, it is noted that this injection locking is passive and long-term stable, that is, no ongoing adjustment or control is needed and the time intervals at which injection locking has to be (re- )performed large, much larger than usual application cycles.

Moreover, the general applicability as well as the low amount of equipment needed to implement injection locking also enables scalable injection locking going beyond one laser injecting locking a second laser, but allowing for several laser being injection locked in parallel and/or in series.

## Claims

1. A method for injection locking a first laser onto a second laser, the method comprising the steps of:
a) providing at least part of light emitted by the first laser to the second laser;
b) continuously changing an input parameter of the second laser until a value at which a signal of the second laser shifts is reached;
c) adding the value at which the signal of the second laser shifts to a set of values;
d) repeating steps b) and c) until the set of values converges to a convergence value; and
e) setting the input parameter of the second laser based on the convergence value, thereby injection locking the first laser onto the second laser.

2. The method according to claim 1, further comprising receiving a trigger input to perform the injection locking synchronously to an external event.

3. The method according to claim 1, further comprising detecting that the second laser is not injection locked to the first laser, and performing the injection locking according to the detection.

4. The method according to any one of claims 1 to 3, wherein, in step b), the input parameter of the second laser is continuously decreased, or the input parameter of the second laser is continuously increased.

5. The method according to any one of claims 1 to 4, wherein, in step b), it is determined that the value at which the signal of the second laser shifts is reached by comparing subsequent values of the signal of the second laser.

6. The method according to claim 5, wherein comparing subsequent values of the signal of the second laser includes comparing two subsequent values and determining whether a difference between the two subsequent values exceeds a first predetermined threshold; and/or includes determining a slope of the signal and determining whether the slope of the signal exceeds a second predetermined threshold.

7. The method according to any one of claim 1 to 6, wherein, in step b), continuously changing an input parameter of the second laser is performed in discrete steps such that each value of the input parameter is held for a predetermined period of time.

8. The method according to any one of claims 1 to 7, wherein an output power of the second laser is greater than an output power of the first laser.

9. The method according to any one of claims 1 to 8, wherein the first and the second laser differ in at least one intrinsic property.

10. The method according to any one of claims 1 to 9, wherein the input parameter of the second laser is a current applied to the second laser, or a voltage controlling the current applied to the second laser.

11. The method according to claim 10, wherein the current applied to the second laser is modulated with a triangular waveform.

12. The method according to any one of claims 1 to 11, wherein the signal of the second laser is a signal of a photodiode integrated into the second laser, preferably a photocurrent of the photodiode or a voltage converted from the photocurrent.

13. A system for injection locking a first laser onto a second laser, the system comprising the first laser, the second laser, and a control unit, wherein
the first laser is configured to provide at least part of light emitted by the first laser to the second laser, and
the control unit is configured to perform the steps of:
a) continuously changing an input parameter of the second laser until a value at which an signal of the second laser shifts is reached;
b) adding the value at which the signal of the second laser shifts to a set of values;
c) repeating steps a) and b) until the set of values converges to a convergence value; and
d) setting the input parameter of the second laser based on the convergence value, thereby injection locking the first laser onto the second laser.

14. The system according to claim 13, wherein the control unit is further configured to receive a trigger input to perform the injection locking synchronously to an external event.

15. The system according to claim 13, wherein the control unit is further configured to detect that the second laser is not injection locked to the first laser, and perform the injection locking according to the detection.
